(19) Europäisches Patentamt
European Patent Office
Office européen des brevets

(11) **EP 4 468 370 A1**

(12) **EUROPEAN PATENT APPLICATION**

(43) Date of publication:
**27.11.2024 Bulletin 2024/48**

(21) Application number: **23174405.3**

(22) Date of filing: **20.05.2023**

(51) International Patent Classification (IPC):
**H01L 31/0216** (2014.01) **H01L 27/144** (2006.01)
**H01L 31/0232** (2014.01)

(52) Cooperative Patent Classification (CPC):
**H01L 31/02162; H01L 27/14601; H01L 27/14607;
H01L 27/14625; H01L 31/02327**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Sensirion AG
8712 Stäfa (CH)**

(72) Inventors:
• **RÜTHEMANN, Lukas
8050 Zürich (CH)**
• **GÜTLE, Frank
8706 Meilen (CH)**
• **BANJEVIC, Mirjana
8005 Zürich (CH)**
• **MÜLLER, Martin
8706 Meilen (CH)**

(54) **EMI ROBUST PHOTODETECTOR CHIP**

(57)    An EMI robust photodetector chip is proposed. The photodetector chip comprises a "blind" photodiode, which is not sensitive to EM radiation of a target wavelength, and an "open" photodiode which is sensitive to the target wavelength. Both blind and open photodiodes are sensitive to an interference wavelength. The blind and open photodiode are arranged and configured symmetrically such that a difference of their photocurrents is not sensitive to the interference wavelength. The blind photodiode is not sensitive to the target wavelength because it is covered by a 3D tiling of chip metallization layers characterized in that tiles in the same layer are not contiguous but a projection of all tiles onto the chip plane covers the photodiode.

Fig 1

## Description

## Technical Field

The invention relates to photodetector chips robust against electromagnetic interference.

## Background Art

Photodetectors are devices sensitive to electromagnetic radiation ("light") utilizing various light-matter interactions. Photodetectors comprising photodiodes---semiconductor devices converting light into electrical current---are a particularly cost-effective variant because they can be mass-produced using tools and processes of the semiconductor industry.

Measuring light with a photodetector enables the construction of other types of sensors whose target quantity interacts with light in a known manner. To be able to tell light that interacted with the target quantity from light of an interfering source, additional features such as filters on photodiodes and differential measurements of more than one photodiode may be employed.

Optical particulate matter sensors, for instance, detect particles by illuminating a detection volume and measuring particle-scattered light with photodetectors. In WO2021/213692A1, a photodetector comprised in a particulate matter sensor is partitioned into photodiodes that are covered with a black layer created by inkjet printing, and photodiodes that are not covered. The black layer shields the photodiodes from light scattered by particles. A control unit is configured to apply differential processing to the signals of the shielded and the unshielded photodiodes to cancel out spurious signals due to electromagnetic interference (EMI), which affect both shielded and unshielded photodiodes equally when designed symmetrically.

A particular type of filter for electromagnetic radiation are frequency selective surfaces (FSS), see https://doi.org/10.3390/app8091689 for a review. Frequency selective surfaces may be realized by arranging planar metal tiles in a two-dimensional periodic structure on a dielectric substrate. The exact spacing and dimensions of the tiles influence the resonance frequency and thus the stop band of the FSS.

## Disclosure of the Invention

It is an object of the invention to provide a photodetector that is robust against electromagnetic interference and mass-producible using tools and processes of the semiconductor industry.

This object is achieved by a photodetector according to claim 1. A photodetector chip for sensing electromagnetic radiation of a first wavelength extends in a plane with a top side and a bottom side, comprising a substrate, a first and a second photodiode in or on the substrate configured to generate photo currents, a layer stack covering the second photodiode on its top side, a subtractor unit configured to output a quantity indicative of a difference of the photo currents, where the photodiodes are arranged, and the layer stack is configured such that the second photodiode receives less electromagnetic radiation of the first wavelength incident on the chip from the top side than the first photodiode.

The structure of the photodetector chip is such that more electromagnetic radiation of the first wavelength, the target wavelength, incident from the top side arrives at the first photodiode than at the second photodiode. Differential processing of the two photodiode outputs then yields a signal that still has sensitivity to the target wavelength. Depending on the use-case, the necessary difference in electromagnetic radiation intensity reaching the first and the second photodiode can vary. The difference is preferably large compared to a difference of an interference quantity, such as electromagnetic radiation at a second, interference wavelength. Preferably the ratio of electromagnetic radiation intensity at the target wavelength reaching the first photodiode to the electromagnetic radiation intensity at the target wavelength reaching the second photodiode is less than 5%, more preferably less than 1%.

In an embodiment, the target wavelength is from 190 nm to 1100 nm.

If the target wavelength is from 190nm to 1100nm then silicon photodiodes can be used, which is particularly cost-effective. Also, this is an interesting wavelength range for optical particulate matter sensors utilizing a near-infrared light source, such as one centered at 940 nm.

In an embodiment, the photodetector chip comprises metallization layers, and the layer stack comprises metal patches in several metallization layers such that patches in the same layer are not contiguous, and an aggregated normal projection of the patches onto the chip plane substantially covers a normal projection of the second photodiode onto the chip plane.

A simple approach to blocking the passage of the target wavelength to the second photodiode would be to cover the entire area of the second photodiode by a single contiguous metal layer of a metallization layer above the photodiode. However, such a metal layer may on the one hand block the target wavelength effectively, but an interference wavelength as well may be attenuated so much that the difference of the two photodiode outputs at the interference wavelength may be not negligible. In terms of optical power, the attenuation of the frequency-selective layer stack at the interference wavelength is preferably less than 0.4 dB, more preferably less than 0.04 dB.

It was surprisingly found that "partitioning" a contiguous single layer metal covering of the second photodiode into patches and "distributing" them across several metallization layers in the direction normal to the chip plane such that patches in the same layer are not contiguous but the aggregate normal projection of the partition still substantially covers the normal projection of the second photodiode solves the attenuation problem: The target wavelength is still effectively blocked while the larger interference wavelength is barely attenuated. The partitioning mentioned above is only meant as an intuitive explanation and not an actual manufacturing process. Metallization layers of any shape may be patterned during chip manufacturing using for instance iterations of metal layer deposition, metal etching, dielectric gap fill, and planarization. Thus, any point of the second photodiode may be covered by projections of multiple metal patches above it. "Substantially covered" means that at least 70% of the area are covered, and all but areas of a minimum caliper diameter smaller than twice the target wavelength and a maximum caliper diameter smaller than ten times the target wavelength are covered.

In an embodiment, the photodetector chip comprises metal patches with in-plane dimensions between 0.5 times and 10 times the first wavelength.

Dimensioning the width and the length of the metal patches of the order of the target wavelength ensures that the target wavelength effectively reflects from / diffracts at the metal patches. In an embodiment where the target wavelength is around 1 um, the metal patches may be tiles where the in-plane length of the tiles is between 2.5 and 5 um, the in-plane width is between 0.5 and 1.5 um, and the normal height is between 0.5 and 1 um.

In an embodiment, the photodetector chip has the photodiodes arranged and the layer stack configured such that the photodiodes receive substantially the same amount of electromagnetic radiation of a second wavelength incident on the chip.

In some use-cases, a main source of interference is electromagnetic radiation of a second wavelength larger than the target wavelength, the interference wavelength. To ensure that the differential processing of the first and second photodiode cancels the contribution to the measurement signal of the interference radiation, it is preferable that substantially the same amount of electromagnetic radiation at the interference wavelength incident on the chip reaches the first and the second photodiodes. Substantially the same means that the difference in optical intensity at the interference wavelength between the first and the second photodiode is small compared to the difference in optical intensity at the target wavelength.

In an embodiment, the interference wavelength is greater than 1 cm, preferably greater than 10 cm.

A main EMI frequency for photodetectors is centered around 2.45 GHz (WiFi, Bluetooth®), that is, 12.24 cm wavelength.

In an embodiment, the photodetector chip comprises a substrate made of silicon.

In an embodiment, the photodetector chip is a CMOS chip.

It may be advantageous to have an analog-to-digital converter (ADC) as close to the analog outputs of the photodiodes as possible. Leads to the photodiodes may pick up EMI asymmetrically, and the longer the leads the larger the possible asymmetry. Computing a difference of the two photodiodes would then imperfectly cancel the EMI interference. The differential processing of the two photodiode outputs may be performed digitally.

In an embodiment, the photodetector chip is a CMOS chip, and the photodiodes are silicon photodiodes integrated in the CMOS chip.

It is cost-effective to manufacture the photodetector chip monolithically using standard tools and processes of the semiconductor industry. CMOS circuitry, silicon photodiodes, and metallization layers of any shape are part of the standard manufacturing process of a CMOS chip.

In an embodiment, the subtractor unit of the photodetector chip comprises a transimpedance amplifier one input of which is connected to the cathode of the first photodiode, and the other input of which is connected to the cathode of the second photodiode.

To keep noise to a minimum, it may be advantageous to compute the difference of the photocurrents in an analog manner. Leads to the photodiodes may pick up EMI asymmetrically, and the longer the leads the larger the possible asymmetry. To make the leads to the photodiodes as short as possible, the cathodes of the photodiodes may be directly connected to the transimpedance amplifier inputs. In this manner, the two photocurrents are subtracted with the most symmetric possible influence of EMI, thus minimizing the EMI in the difference.

In an embodiment, the photodetector chip comprises processing circuitry configured to derive a signal based on the subtractor unit output.

One advantage of the invention is its compatibility with CMOS processes. The photodetector chip may be endowed with signal processing circuitry capable of further processing the subtractor unit output indicative of a difference of the open and blind photodiode currents.

The signal processing may comprise a calibration step transforming the current difference into a unit of measurement representing a target quantity interacting with light of the target wavelength in a predetermined manner, and / or it may comprise a statistical analysis of a plurality of subtractor unit outputs. By way of example, the signal processing unit may output a particulate matter concentration in ambient air by analyzing at 40 kHz subtractor unit outputs due to light scattering off individual particulates crossing a light beam of a target wavelength.

## Brief description of the drawings

Figure 1 shows a top view of a photodetector chip according to an embodiment of the invention.

Figure 2 shows a side view of a cut of a photodetector chip according to an embodiment of the invention.

Figure 3 shows a SEM image of a cut of a photodetector chip according to an embodiment of the invention.

Figure 4 shows top views of one unit cell each of six metallization layers of a photodetector chip according to an embodiment of the invention, and an aggregated projection.

Figure 5 shows a tiling of the blind photodiodes according to an embodiment of the invention.

Figure 6 shows a subtractor unit according to an embodiment of the invention.

Figure 7 shows a plot of a radiative immunity EMI test of a particle counter utilizing a photodetector chip according to an embodiment of the invention.

Figure 8 shows a plot of a radiative immunity EMI test of a particle counter utilizing a photodetector with a continuous metal layer as shielding.

Figure 9 shows a COMSOL® Multiphysics simulation of a planar electromagnetic wave with 940 nm wavelength incident on a 4um x 4um unit cell of a reference photodiode according to an embodiment of the invention.

**Detailed description of ways carrying out the invention**

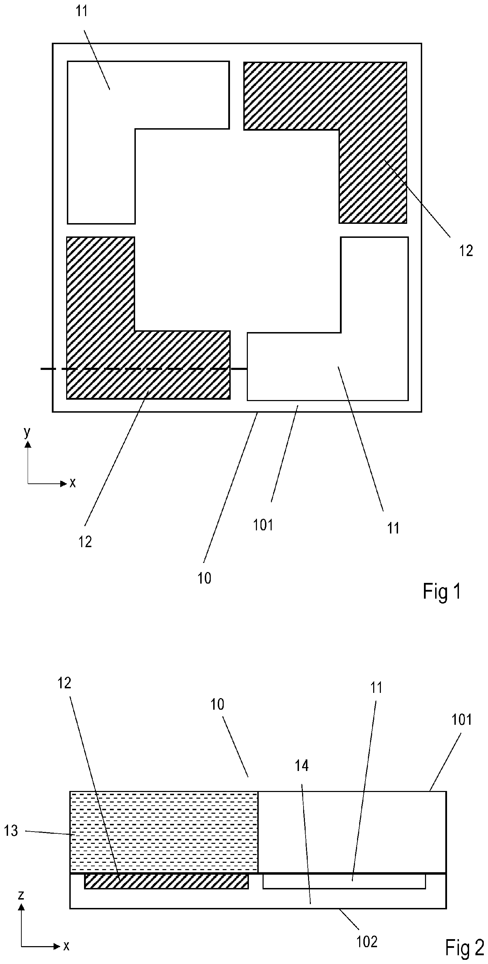

Figure 1 and Figure 2 show the basic make-up of an EMI robust photodetector. In a chip 10, two types of silicon photodiodes are integrated in the silicon substrate 14, "open" ones 11 and "blind" or "reference" ones 12. A design with two open 11 and two blind 12 photodiodes is shown. Clearly, more or fewer of each type may be employed. As will be explained below, the chip metallization layer stack 13 is configured such that the open photodiodes 11 receive electromagnetic radiation of both a target and an interference wavelength, whereas the blind ones 12 only receive the interference wavelength. Subtracting the blind photocurrent from the open photocurrent yields a signal that is free of interference.

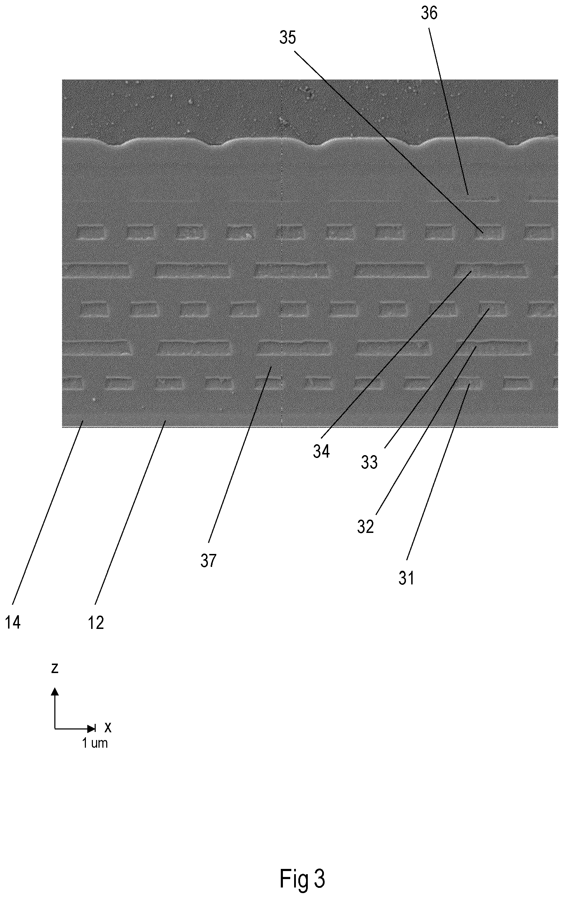

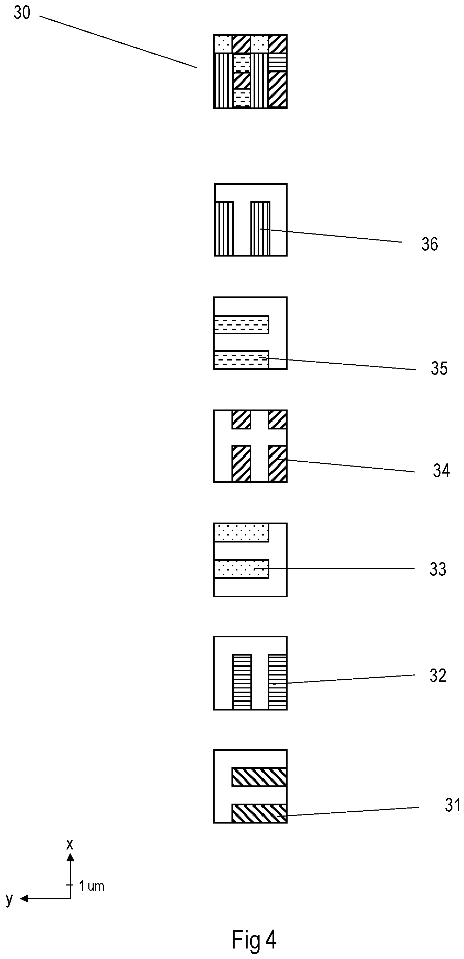

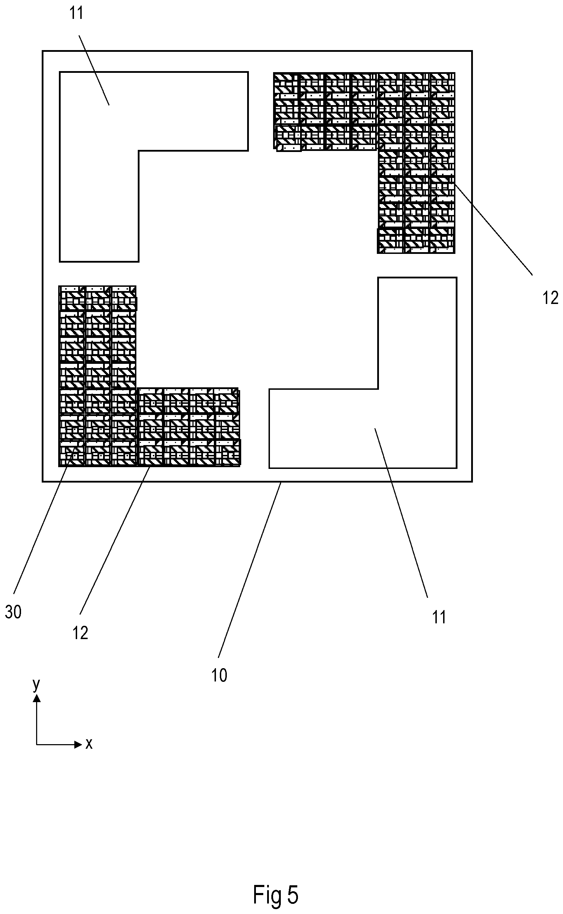

The open photodiodes 11 are arranged in the chip 10 such that only layers transparent to a target wavelength of 940 nm lie above the photodiodes, such as silicon oxide or silicon nitride. "Above/below" and "top/bottom" are with respect to the z-direction normal to the chip x/y-plane. Alternatively, the chip layers above the open type photodiodes 11 may be completely etched away, such that the open silicon photodiodes 11 have no layer above it other than a nm-layer of native oxide that grows when silicon is exposed to ambient air. The blind photodiodes 12 are arranged in the chip 10 such that a three-dimensional pattern of metal tiles 31-36 is arranged above the photodiodes, best seen in a part of a chip cross-section depicted in Figure 3. The metal tiles 31-36 are part of the standard metallization layers metal 1 to metal 6 deposited and etched during chip manufacturing. The metal tiles 31-36 in each metallization layer are periodically arranged with a unit cell of 4 um by 4 um, comprised of 16 "pixels" of 1um² each, see Figure 4. In this embodiment, the unit cell metal design 31 of the first metallization layer is two parallel rectangles of 3 um by 1um, spaced 1 um apart, each filling out three pixels of the 4x4 grid of the unit cell. This basic design is repeated in each of the six metallization layers above the blind photodiode but shifted by one pixel and rotated 90 degrees every time when ascending a layer. The resulting three-dimensional pattern is a set of metal tiles where no two tiles in the same layer are contiguous, but the normal projection 30 of the union of all rectangles completely covers the normal projection of the blind photodiode, see Figure 5. It is clear to the skilled person that the coverage does not need to be complete, as long as uncovered areas of the projection are small with respect to the target wavelength, in the sense that a minimal caliper diameter of the area is less than the target wavelength. A caliper diameter or Feret diameter of a closed curve in a plane is the normal distance between two parallel lines touching the curve but not intersecting the curve anywhere.

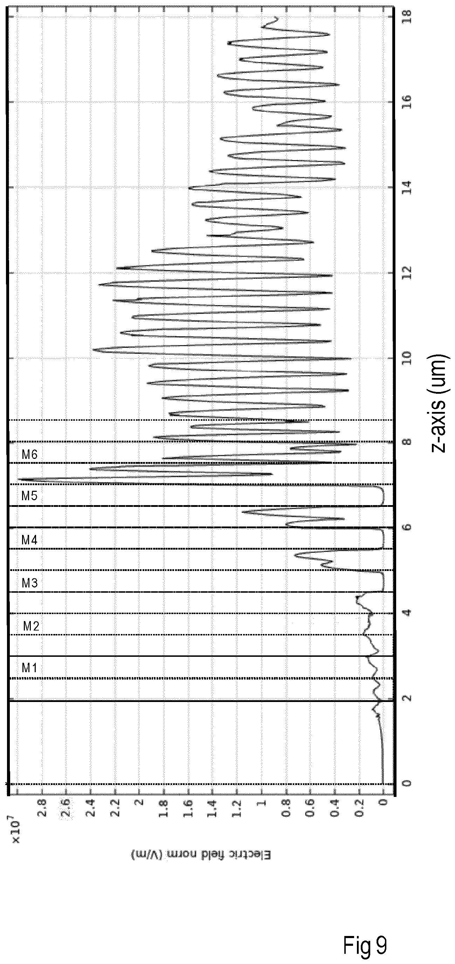

This three-dimensional metal structure acts as a low-pass filter and effectively blocks electromagnetic radiation of the target wavelength. This is evidenced in Figure 9 showing the progressive attenuation of a planar wave of 940 nm wavelength incident onto a silicon chip with aluminum metallization layers M1 through M6. The metallization layers are interspersed with silicon oxide dielectric layers. The simulation was done with the commercially available Multiphysics simulation tool COMSOL®. The abscissa measures the normal distance from the silicon substrate, and the ordinate measures the amplitude of the electric field component of the incident electromagnetic radiation along a normal through the center of a 4 um by 4 um unit cell, the projection 30 of which is depicted in Figure 4. The silicon substrate extends up to z=2 um, the metal layer stack from z=2um to z=8.5 um, and an adjoining air volume is modeled from z=8.5 um to z=18 um. The 940 nm electromagnetic plane wave is incident in negative z-direction from z=18 um.

The amplitude of the electric field vector at the silicon photodiode below the layer stack at z<2 um is less than 10% of the incident amplitude at z>16 um. An attenuation in terms of optical power at the target wavelength of at least 95% is desired, more preferably an attenuation of 99%.

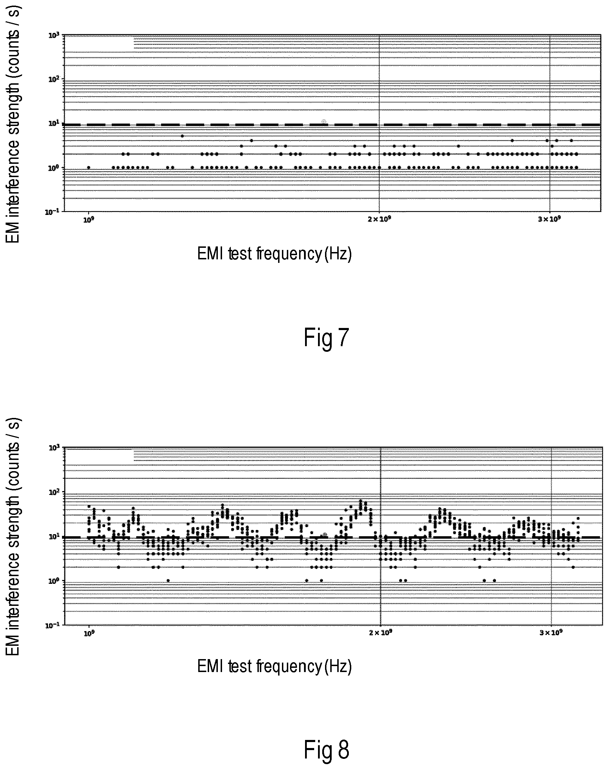

On the other hand, electromagnetic radiation of a wavelength larger than 1 cm, particularly larger than 10 cm would be barely attenuated. This is because on the one hand, it interacts coherently with metal tiles that are many orders of magnitude smaller than the wavelength, and on the other hand, the path the electromagnetic radiation travels from top to bottom of the chip is also much less than the wavelength. As a result, both open and blind photodiodes are affected substantially the same by interference wavelengths. Therefore, subtracting the blind photocurrent from the open photocurrent yields a signal that is free of interference. The meaning of "affected substantially the same" depends on the context of the use-case in which the photodetector is deployed. For example, Figure 7 shows the result plot of a radiated immunity EMI test with frequencies between 1 GHz and 3.2 GHz of an optical particle counter utilizing a photodetector according to an embodiment of the invention. The ordinate shows the EMI strength in units of particle counts per second, that is, false positives. The dashed line describes a threshold, under which the signal is considered regular noise. For all tested EMI frequencies, the false-positive rate is well below the threshold, proving that the photocurrents of blind and open photodiodes are affected substantially the same.

On the other hand, Figure 8 depicts the result plot of an analogous EMI test utilizing a simple contiguous metal layer on top of the blind photodiodes to block the target wavelength of 940 nm. However, because the skin depth of the EMI frequencies tested is comparable to the thickness of the metallization layers used in chip manufacturing (order of microns), the EMI frequencies as well are non-negligibly attenuated. As a result, the difference in photocurrents of blind and open photodiodes is non-negligible and results in false-positive rates well above the threshold for many frequencies tested.

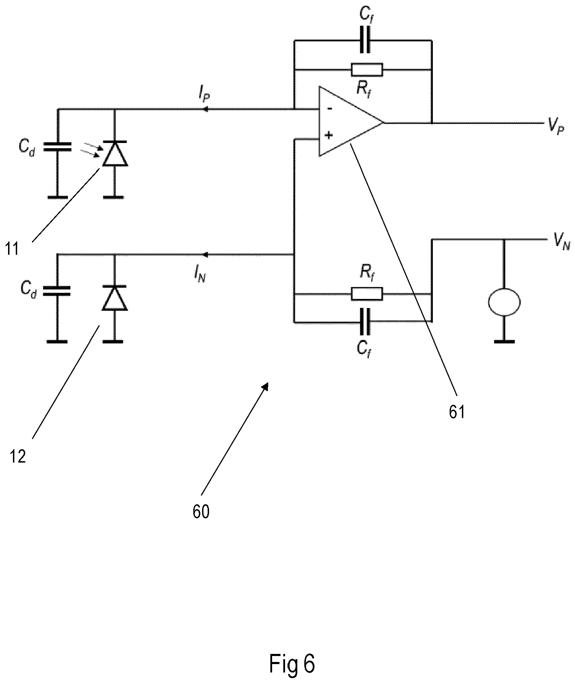

When computing the difference of the photocurrents of the open and the blind photodiodes it is advantageous to do so as close to the photodiode outputs as possible. A preferred analog realization of a subtractor unit for two integrated photodiodes as a transimpedance amplifier (TIA) is shown schematically in Figure 6. The cathodes of the open 11 and the blind photodiodes 12 are interconnected in the chip metal layers to the inverting and non-inverting inputs of an operational amplifier 61, respectively. In this way, the current difference is translated into a voltage difference according to the formula of the impedance transfer function

$$\frac{V_P - V_N}{I_P - I_N} = \frac{A}{A+1} \; \frac{R_f}{1 + R_f\left(C_f + \frac{C_d}{A+1}\right)s}.$$

In this formula, s is the frequency parameter in the Laplace transform of the circuit shown in Figure 6, A is the gain of the operational amplifier 61, $C_d$ is the junction capacitance of the photodiodes shown in an equivalent circuit representation, $I_P$ and $I_N$ are the currents flowing into the open and blind photodiode 11 and 12, respectively, $R_f$ are the load resistances, $C_f$ the feedback capacitances used to ensure the stability and define the bandwidth of the TIA, $V_P$ is the output voltage of the operational amplifier 61, and $V_N$ is the reverse bias voltage of the photodiodes. In a preferred embodiment, $V_N$ = 600 mV, $R_f$ = 2 MΩ, $C_f$ = 0.8 pF.

The voltage difference may be digitized by an ADC for further processing or output as a useful signal. The length of the leads (microns) is much shorter than the interference wavelength (centimeters), and thus the leads of open and blind photodiodes are affected by EMI symmetrically, reducing noise in the difference to a minimum.

This embodiment with a single TIA is preferred over a more straightforward implementation using one TIA amplifier per photodiode and then computing the output voltage difference in an ADC because imperfect matching of the gains of the two operational amplifiers would introduce additional inaccuracies.

## List of reference signs

| 10 | chip |
| 101 | chip top side |
| 102 | chip bottom side |
| 11 | open photodiode |
| 12 | blind or reference photodiode |
| 13 | chip metallization layer stack |
| 14 | silicon substrate |
| 30 | normal projection of union of unit cells |
| 31-36 | metal tile in unit cell of metal layers 1 to 6 |
| 37 | silicon oxide dielectric layer |
| 60 | subtractor unit |
| 61 | transimpedance amplifier |

## Claims

1.   A photodetector chip (10) for sensing electromagnetic radiation of a first wavelength,
     the chip extending in a plane with a top side (101) and a bottom side (102), comprising a substrate (14),

     a first (11) and a second photodiode (12) in or on the substrate configured to generate photo currents,
     a layer stack (13) covering the second photodiode (12) on its top side,
     a subtractor unit (60) configured to output a quantity indicative of a difference of the photo currents,
     **characterized in that** the photodiodes (11, 12) are arranged, and the layer stack (13) is configured such that the second photodiode (12) receives less electromagnetic radiation of the first wavelength incident on the chip (10) from the top side (101) than the first photodiode (11).

2.   A photodetector chip (10) according to claim 1, wherein the first wavelength is from 190 nm to 1100 nm.

3.   A photodetector chip (10) according to any preceding claim comprising metallization layers,

wherein the layer stack (13) comprises metal patches (31-36) in several metallization layers such that

patches in the same layer are not contiguous, and

an aggregated normal projection (30) of the patches (31-36) onto the chip plane substantially covers a normal projection of the second photodiode (12) onto the chip plane.

4. A photodetector chip (10) according to claim 2 or 3 wherein in-plane dimensions of the metal patches (31-36) are between 0.5 times and 10 times the first wavelength.

5. A photodetector chip (10) according to any preceding claim, wherein
the photodiodes (11, 12) are arranged, and the layer stack (13) is configured such that the photodiodes (11, 12) receive substantially the same amount of electromagnetic radiation of a second wavelength incident on the chip.

6. A photodetector chip (10) according to claim 5, wherein the second wavelength is greater than 1 cm, preferably greater than 9.4 cm.

7. A photodetector chip (10) according to any of the previous claims, wherein the substrate (14) is silicon.

8. A photodetector chip (10) according to claim 7, wherein the photodiodes (11, 12) are silicon photodiodes.

9. A photodetector chip (10) according to any of the previous claims, wherein the chip (10) is a CMOS chip.

10. A photodetector chip (10) according to claim 9 wherein the photodiodes (11, 12) are silicon photodiodes integrated in the CMOS chip.

11. A photodetector chip (10) according to claim 9 or 10, wherein the subtractor unit (60) comprises a transimpedance amplifier (601) one input of which is connected to the cathode of the first photodiode (11), and the other input of which is connected to the cathode of the second photodiode (12).

12. A photodetector chip (10) according to claim 9 to 11, comprising processing circuitry configured to derive a signal based on the subtractor unit (60) output.

11

12

12

101

11

10

y

x

Fig 1

12

10

11

101

13

14

z

x

102

Fig 2

Fig 3

30

36

35

34

33

32

31

x

y ← | 1 um

Fig 4

Fig 5

Fig 6

Fig 7

Fig 8

Fig 9

Europäisches
Patentamt
European
Patent Office
Office européen
des brevets

# EUROPEAN SEARCH REPORT

Application Number

EP 23 17 4405

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 132 679 B2 (MAXIM INTEGRATED PRODUCTS [US]) 20 November 2018 (2018-11-20) * the whole document * | 1-10,12 | INV. H01L31/0216 H01L27/144 H01L31/0232 |
| X | US 2022/018708 A1 (ROIZIN YAKOV [IL] ET AL) 20 January 2022 (2022-01-20) * the whole document * | 1-12 | |
| X | WO 2015/151651 A1 (SHARP KK [JP]) 8 October 2015 (2015-10-08) * the whole document * | 1-12 | |
| A | KR 2010 0121718 A (SILICONFILE TECHNOLOGIES INC [KR]) 19 November 2010 (2010-11-19) * figures 6,10 * | 3,4 | |

TECHNICAL FIELDS
SEARCHED        (IPC)

H01L

The present search report has been drawn up for all claims

| Place of search | Date of completion of the search | Examiner |
|---|---|---|
| Berlin | 3 November 2023 | Voignier, Vincent |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                    EP 23 17 4405

This annex lists the patent family members relating to the patent documents cited in the above-mentioned European search report.
The members are as contained in the European Patent Office EDP file on
The European Patent Office is in no way liable for these particulars which are merely given for the purpose of information.

03-11-2023

| Patent document cited in search report | | Publication date | Patent family member(s) | | Publication date |
|---|---|---|---|---|---|
| US 10132679 | B2 | 20-11-2018 | CN | 105405914 A | 16-03-2016 |
| | | | US | 2015338273 A1 | 26-11-2015 |
| US 2022018708 | A1 | 20-01-2022 | NONE | | |
| WO 2015151651 | A1 | 08-10-2015 | CN | 106104232 A | 09-11-2016 |
| | | | JP | 6072978 B2 | 01-02-2017 |
| | | | JP | WO2015151651 A1 | 13-04-2017 |
| | | | US | 2017138786 A1 | 18-05-2017 |
| | | | WO | 2015151651 A1 | 08-10-2015 |
| KR 20100121718 | A | 19-11-2010 | CN | 101887142 A | 17-11-2010 |
| | | | EP | 2251718 A1 | 17-11-2010 |
| | | | KR | 20100121718 A | 19-11-2010 |
| | | | US | 2010283086 A1 | 11-11-2010 |

EPO FORM P0459

For more details about this annex : see Official Journal of the European Patent Office, No. 12/82

**EP 4 468 370 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021213692 A1